# EUROPEAN PATENT SPECIFICATION

(11) **EP 3 872 868 B1**
(45) Date of publication and mention of the grant of the patent: **07.06.2023**
(21) Application number: 20159311.8
(22) Date of filing: 25.02.2020
(51) Int. Cl.: H01L 31/0304, H01L 31/056, H01L 31/0687

(54) **MULTIJUNCTION SOLAR CELLS FOR LOW TEMPERATURE OPERATION**
SOLARZELLEN MIT MEHRFACHÜBERGÄNGEN FÜR NIEDERTEMPERATURBETRIEB
CELLULES SOLAIRES MULTIJONCTIONS POUR UN FONCTIONNEMENT À BASSE TEMPÉRATURE

(43) Date of publication of application: 01.09.2021
(73) Proprietor: SolAero Technologies Corp., a corporation of the state of Delaware, Albuquerque, NM 87123 (US)
(72) Inventor: DERKACS, Daniel, Albuquerque, NM New Mexico 87111 (US)
(74) Representative: de Rooij, Mathieu Julien

(56) References cited:
- US-A1- 2010 282 305
- US-B1- 9 768 329
- CHEN HUNG-LING ET AL: "A 19.9%-efficient ultrathin solar cell based on a 205-nm-thick GaAs absorber and a silver nanostructured back mirror", NATURE ENERGY, NATURE PUBLISHING GROUP UK, LONDON, vol. 4, no. 9, 5 August 2019 (2019-08-05), pages 761-767, XP036885065, DOI: 10.1038/S41560-019-0434-Y [retrieved on 2019-08-05]
- CLAIBORNE O MCPHEETERS ET AL: "Performance benefits for thin film solar cells incorporating semiconductor heterostructures and light trapping", PHOTOVOLTAIC SPECIALISTS CONFERENCE (PVSC), 2012 38TH IEEE, IEEE, 3 June 2012 (2012-06-03), pages 1566-1571, XP032258111, DOI: 10.1109/PVSC.2012.6317893 ISBN: 978-1-4673-0064-3
- ZHU LIN ET AL: "Design of InGaP/GaAs/lnGaAs multi-junction cells with reduced layer thicknesses using light-trapping rear texture", 2017 IEEE 44TH PHOTOVOLTAIC SPECIALIST CONFERENCE (PVSC), IEEE, 25 June 2017 (2017-06-25), pages 3528-3533, XP033452431, DOI: 10.1109/PVSC.2017.8366274 [retrieved on 2018-05-25]

## Description

### BACKBROUND OF THE INVENTION

### Field of the Invention

The present disclosure relates to solar cells and the fabrication of solar cells, and more particularly to the design and specification of lattice matched multijunction solar cells adapted for space missions.

### Description of the Related Art

Solar power from photovoltaic cells, also called solar cells, has been predominantly provided by silicon semiconductor technology. In the past several years, however, high-volume manufacturing of III-V compound semiconductor multijunction solar cells for space applications has accelerated the development of such technology. Compared to silicon, III-V compound semiconductor multijunction devices have greater energy conversion efficiencies and generally more radiation resistance, although they tend to be more complex to properly specify and manufacture. Typical commercial III-V compound semiconductor multijunction solar cells have energy efficiencies that exceed 29.5% under one sun, air mass 0 (AM0) illumination, whereas even the most efficient silicon technologies generally reach only about 18% efficiency under comparable conditions. The higher conversion efficiency of III-V compound semiconductor solar cells compared to silicon solar cells is in part based on the ability to achieve spectral splitting of the incident radiation through the use of a plurality of photovoltaic regions with different band gap energies, and accumulating the current from each of the regions.

In satellite and other space related applications, the size, mass and cost of a satellite power system are dependent on the power and energy conversion efficiency of the solar cells used. Putting it another way, the size of the payload and the availability of on-board services are proportional to the amount of power provided. Thus, as payloads use increasing amounts of power as they become more sophisticated, and missions and applications anticipated for five, ten, twenty or more years, the power-to-weight ratio and lifetime efficiency of a solar cell becomes increasingly more important, and there is increasing interest not only the amount of power provided at initial deployment, but over the entire service life of the satellite system, or in terms of a design specification, the amount of power provided at the "end of life" (EOL) which is affected by the radiation exposure of the solar cell over time in a space environment.

Typical III-V compound semiconductor solar cells are fabricated on a semiconductor wafer in vertical, multijunction structures or stacked sequence of solar subcells, each subcell formed with appropriate semiconductor layers and including a p-n photoactive junction. Each subcell is designed to convert photons over different spectral or wavelength bands to electrical current. After the sunlight impinges on the front of the solar cell, and photons pass through the subcells, with each subcell being designed for photons in a specific wavelength band. After passing through a subcell, the photons that are not absorbed and converted to electrical energy propagate to the next subcells, where such photons are intended to be captured and converted to electrical energy.

The individual solar cells or wafers are then disposed in horizontal arrays, with the individual solar cells connected together in an electrical series and/or parallel circuit. The shape and structure of an array, as well as the number of cells it contains, are determined in part by the desired output voltage and current needed by the payload or subcomponents of the payload, the amount of electrical storage capacity (batteries) on the spacecraft, and the power demands of the payloads during different orbital configurations.

A solar cell designed for use in a space vehicle (such as a satellite, space station, or an interplanetary mission vehicle), has a sequence of subcells with compositions and band gaps which have been optimized to achieve maximum energy conversion efficiency for the AM0 solar spectrum in space. The AM0 solar spectrum in space is notably different from the AM1.5 solar spectrum at the surface of the earth, and accordingly terrestrial solar cells are designed with subcell band gaps optimized for the AM1.5 solar spectrum.

There are substantially more rigorous qualification and acceptance testing protocols used in the manufacture of space solar cells to ensure that space solar cells can operate satisfactorily at the wide range of temperatures and temperature cycles encountered in space. These testing protocols include (i) high-temperature thermal vacuum bake-out; (ii) thermal cycling in vacuum (TVAC) or ambient pressure nitrogen atmosphere (APTC); and in some applications (iii) exposure to radiation equivalent to that which would be experienced in the space mission, and measuring the current and voltage produced by the cell and deriving cell performance data.

As used in this disclosure and claims, the term "space-qualified" shall mean that the electronic component (i.e., the solar cell) provides satisfactory operation under the high temperature and thermal cycling test protocols. The exemplary conditions for vacuum bake-out testing include exposure to a temperature of +100 °C to +135 °C (e.g., about +100 °C, +110 °C, +120 °C, +125 °C, +135 °C) for 2 hours to 24 hours, 48 hours, 72 hours, or 96 hours; and exemplary conditions for TVAC and/or APTC testing that include cycling between temperature extremes of -180 °C (e.g., about -180 °C, -175 °C, -170 °C, -165 °C, -150 °C, -140 °C, -128 °C, - 110 °C, -100 °C, -75 °C, or -70 °C) to +145 °C (e.g., about +70 °C, +80 °C, +90 °C, +100 °C, +110 °C, +120 °C, +130 °C, +135 °C, or +145 °C) for 600 to 32,000 cycles (e.g., about 600, 700, 1500, 2000, 4000, 5000, 7500, 22000, 25000, or 32000 cycles), and in some space missions up to +180° C. See, for example, Fatemi et al., "Qualification and Production of Emcore ZTJ Solar Panels for Space Missions," Photovoltaic Specialists Conference (PVSC), 2013 IEEE 39th (DOI: 10. 1109/PVSC 2013 6745052). Such rigorous testing and qualifications are not generally applicable to terrestrial solar cells and solar cell arrays.

Conventionally, such measurements are made for the AM0 spectrum for "one-sun" illumination, but for PV systems which use optical concentration elements, such measurements may be made under concentrations of 2x, 100x, or 1000x or more.

The space solar cells and arrays experience a variety of complex environments in space missions, including the vastly different illumination levels and temperatures seen during normal earth orbiting missions, as well as even more challenging environments for deep space missions, operating at different distances from the sun, such as at 0.7, 1.0 and 3.0AU (AU meaning astronomical units). The photovoltaic arrays also endure anomalous events from space environmental conditions, and unforeseen environmental interactions during exploration missions. Hence, electron and proton radiation exposure, collisions with space debris, and/or normal aging in the photovoltaic array and other systems could cause suboptimal operating conditions that degrade the overall power system performance, and may result in failures of one or more solar cells or array strings and consequent loss of power.

A further distinctive difference between space solar cell arrays and terrestrial solar cell arrays is that a space solar cell array utilizes welding and not soldering to provide robust electrical interconnections between the solar cells, while terrestrial solar cell arrays typically utilize solder for electrical interconnections. Welding is required in space solar cell arrays to provide the very robust electrical connections that can withstand the wide temperature ranges and temperature cycles encountered in space such as from -175° C to +180° C. In contrast, solder joints are typically sufficient to survive the rather narrow temperature ranges (e.g., about -40° C to about +50° C) encountered with terrestrial solar cell arrays.

A further distinctive difference between space solar cell arrays and terrestrial solar cell arrays is that a space solar cell array utilizes silver-plated metal material for interconnection members, while terrestrial solar cells typically utilize copper wire for interconnects. In some embodiments, the interconnection member can be, for example, a metal plate. Useful metals include, for example, molybdenum; a nickel-cobalt ferrous alloy material designed to be compatible with the thermal expansion characteristics of borosilicate glass such as that available under the trade designation KOVAR from Carpenter Technology Corporation; a nickel iron alloy material having a uniquely low coefficient of thermal expansion available under the trade designation Invar, FeNi36, or 64FeNi; or the like.

An additional distinctive difference between space solar cell arrays and terrestrial solar cell arrays is that space solar cell arrays typically utilize an aluminum honeycomb panel for a substrate or mounting platform. In some embodiments, the aluminum honeycomb panel may include a carbon composite face sheet adjoining the solar cell array. In some embodiments, the face sheet may have a coefficient of thermal expansion (CTE) that substantially matches the CTE of the bottom germanium (Ge) layer of the solar cell that is attached to the face sheet. Substantially matching the CTE of the face sheet with the CTE of the Ge layer of the solar cell can enable the array to withstand the wide temperature ranges encountered in space without the solar cells cracking, delaminating, or experiencing other defects. Such precautions are generally unnecessary in terrestrial applications.

Thus, a further distinctive difference of a space solar cell from a terrestrial solar cell is that the space solar cell must include a cover glass over the semiconductor device to provide radiation resistant shielding from particles in the space environment which could damage the semiconductor material. The cover glass is typically a ceria doped borosilicate glass which is typically from three to six mils in thickness and attached by a transparent adhesive to the solar cell.

In summary, it is evident that the differences in design, materials, and configurations between a space-qualified III-V compound semiconductor solar cell and subassemblies and arrays of such solar cells, on the one hand, and silicon solar cells or other photovoltaic devices used in terrestrial applications, on the other hand, are so substantial that prior teachings associated with silicon or other terrestrial photovoltaic system are simply unsuitable and have no applicability to the design configuration of space-qualified solar cells and arrays. Indeed, the design and configuration of components adapted for terrestrial use with its modest temperature ranges and cycle times often teach away from the highly demanding design requirements for space-qualified solar cells and arrays and their associated components.

The assembly of individual solar cells together with electrical interconnects and the cover glass form a so-called "CIC" (Cell-Interconnected-Cover glass) assembly, which are then typically electrically connected to form an array of series-connected solar cells. The solar cells used in many arrays often have a substantial size; for example, in the case of the single standard substantially "square" solar cell trimmed from a 100 mm wafer with cropped corners, the solar cell can have a side length of seven cm or more.

The radiation hardness of a solar cell is defined as how well the cell performs after exposure to the electron or proton particle radiation which is a characteristic of the space environment. A standard metric is the ratio of the end of life performance (or efficiency) divided by the beginning of life performance (EOLBOL) of the solar cell. The EOL performance is the cell performance parameter after exposure of that test solar cell to a given fluence of electrons or protons (which may be different for different space missions or orbits). The BOL performance is the performance parameter prior to exposure to the particle radiation.

Charged particles in space could lead to damage to solar cell structures, and in some cases, dangerously high voltage being established across individual devices or conductors in the solar array. These large voltages can lead to catastrophic electrostatic discharging (ESD) events. Traditionally for ESD protection the backside of a solar array may be painted with a conductive coating layer to ground the array to the space plasma, or one may use a honeycomb patterned metal panel which mounts the solar cells and incidentally protects the solar cells from backside radiation.

The radiation hardness of the semiconductor material of the solar cell itself is primarily dependent on a solar cell's minority carrier diffusion length (Lₘᵢₙ) in the base region of the solar cell (the term "base" region referring to the p-type base semiconductor region disposed directly adjacent to an n-type "emitter" semiconductor region, the boundary of which establishes the p-n photovoltaic junction). The less degraded the parameter Lₘᵢₙ is after exposure to particle radiation, the less the solar cell performance will be reduced. A number of strategies have been used to either improve Lₘᵢₙ, or make the solar cell less sensitive to Lₘᵢₙ reductions. Improving Lₘᵢₙ has largely involved including a gradation in dopant elements in the semiconductor base layer of the subcells so as to create an electric field to direct minority carriers to the junction of the subcell, thereby effectively increasing Lₘᵢₙ. The effectively longer Lₘᵢₙ will improve the cell performance, even after the particle radiation exposure. Making the cell less sensitive to Lₘᵢₙ reductions has involved increasing the optical absorption of the base layer such that thinner layers of the base can be used to absorb the same amount of incoming optical radiation.

Another consideration in connection with the manufacture of space solar cell arrays is that conventionally, solar cells have been arranged on a support and interconnected using a substantial amount of manual labor. For example, first individual CICs are produced with each interconnect individually welded to the solar cell, and each cover glass individually mounted. Then, these CICs are connected in series to form strings, generally in a substantially manual manner, including the welding steps from CIC to CIC. Then, these strings are applied to a panel substrate and electrically interconnected in a process that includes the application of adhesive, wiring, etc. All of this has traditionally been carried out in a manual and substantially artisanal manner.

The energy conversion efficiency of multijunction solar cells is affected by such factors as the number of subcells, the thickness of each subcell, the composition and doping of each active layer in a subcell, and the consequential band structure, electron energy levels, conduction, and absorption of each subcell, as well as the effect of its exposure to radiation in the ambient environment over time. The identification and specification of such design parameters is a non-trivial engineering undertaking, and would vary depending upon the specific space mission and customer design requirements. Since the power output is a function of both the voltage and the current produced by a subcell, a simplistic view may seek to maximize both parameters in a subcell by increasing a constituent element, or the doping level, to achieve that effect. However, in reality, changing a material parameter that increases the voltage may result in a decrease in current, and therefore a lower power output. Such material design parameters are interdependent and interact in complex and often unpredictable ways, and for that reason are not "result effective" variables that those skilled in the art confronted with complex design specifications and practical operational considerations can easily adjust to optimize performance.

Moreover, the current (or more precisely, the short circuit current density J_{sc}) and the voltage (or more precisely, the open circuit voltage V_{oc}) are not the only factors that determine the power output of a solar cell. In addition to the power being a function of the short circuit density (J_{sc}), and the open circuit voltage (V_{oc}), the output power is actually computed as the product of V_{oc} and J_{sc}, and a Fill Factor (FF). As might be anticipated, the Fill Factor parameter is not a constant, but in fact may vary at a value between 0.5 and somewhat over 0.85 for different arrangements of elemental compositions, subcell thickness, and the dopant level and profile. Although the various electrical contributions to the Fill Factor such as series resistance, shunt resistance, and ideality (a measure of how closely the semiconductor diode follows the ideal diode equation) may be theoretically understood, from a practical perspective the actual Fill Factor of a given subcell cannot always be predicted, and the effect of making an incremental change in composition or band gap of a layer may have unanticipated consequences and effects on the solar subcell semiconductor material, and therefore an unrecognized or unappreciated effect on the Fill Factor. Stated another way, an attempt to maximize power by varying a composition of a subcell layer to increase the V_{oc} or J_{sc} or both of that subcell, may in fact not result in high power, since although the product V_{oc} and J_{sc} may increase, the FF may decrease and the resulting power also decrease. Thus, the V_{oc} and J_{sc} parameters, either alone or in combination, are not necessarily "result effective" variables that those skilled in the art confronted with complex design specifications and practical operational considerations can easily adjust to optimize performance.

Furthermore, the fact that the short circuit current density (J_{sc}), the open circuit voltage (V_{oc}), and the fill factor (FF), are affected by the slightest change in such design variables, the purity or quality of the chemical pre-cursors, or the specific process flow and fabrication equipment used, and such considerations further complicates the proper specification of design parameters and predicting the efficiency of a proposed design which may appear "on paper" to be advantageous.

It must be further emphasized that in addition to process and equipment variability, the "fine tuning" of minute changes in the composition, band gaps, thickness, and doping of every layer in the arrangement has critical effect on electrical properties such as the open circuit voltage (V_{oc}) and ultimately on the power output and efficiency of the solar cell.

To illustrate the practical effect, consider a design change that results in a small change in the V_{oc} of an active layer in the amount of 0.01 volts, for example changing the V_{oc} from 2.72 to 2.73 volts. Assuming all else is equal and does not change, such a relatively small incremental increase in voltage would typically result in an increase of solar cell efficiency from 29.73% to 29.84% for a triple junction solar cell, which would be regarded as a substantial and significant improvement that would justify implementation of such design change.

For a single junction GaAs subcell in a triple junction device, a change in V_{oc} from 1.00 to 1.01 volts (everything else being the same) would increase the efficiency of that junction from 10.29% to 10.39%, about a 1% relative increase. If it were a single junction stand-alone solar cell, the efficiency would go from 20.58% to 20.78%, still about a 1% relative improvement in efficiency.

Present day commercial production processes are able to define and establish band gap values of epitaxially deposited layers as precisely as 0.01 eV, so such "fine tuning" of compositions and consequential open circuit voltage results are well within the range of operational production specifications for commercial products.

Another important mechanical or structural consideration in the choice of semiconductor layers for a solar cell is the desirability of the adjacent layers of semiconductor materials in the solar cell, i.e. each layer of crystalline semiconductor material that is deposited and grown to form a solar subcell, have similar or substantially similar crystal lattice constants or parameters.

Here again there are trade-offs between including specific elements in the composition of a layer which may result in improved voltage associated with such subcell and therefore potentially a greater power output, and deviation from exact crystal lattice matching with adjoining layers as a consequence of including such elements in the layer which may result in a higher probability of defects, and therefore lower manufacturing yield.

In that connection, it should be noted that there is no strict definition of what is understood to mean two adjacent layers are "lattice matched" or "lattice mismatched". For purposes in this disclosure, "lattice mismatched" refers to two adjacently disposed materials or layers (with thicknesses of greater than 100 nm) having in-plane lattice constants of the materials in their fully relaxed state differing from one another by less than 0.02% in lattice constant. (Applicant notes that this definition is considerably more stringent than that proposed, for example, in U.S. Patent No. 8,962,993, which suggests less than 0.6% lattice constant difference as defining "lattice mismatched" layers).

In satellite and other space related applications, the size, mass and cost of a satellite power system are dependent on the power and energy conversion efficiency of the solar cells used. Putting it another way, the size of the payload and the availability of on-board services are proportional to the amount of power provided. Thus, as payloads use increasing amounts of power as they become more sophisticated, and missions and applications anticipated for five, ten, twenty or more years, the power-to-weight ratio and lifetime efficiency of a solar cell becomes increasingly more important, and there is increasing interest not only the amount of power provided at initial deployment, but over the entire service life of the satellite system, or in terms of a design specification, the amount of power provided at the "end of life" (EOL) which is affected by the radiation exposure of the solar cell over time in a space environment.

Typical III-V compound semiconductor solar cells are fabricated on a semiconductor wafer in vertical, multijunction structures or stacked sequence of solar subcells, each subcell formed with appropriate semiconductor layers and including a p-n photoactive junction. Each subcell is designed to convert photons over different spectral or wavelength bands to electrical current. After the sunlight impinges on the front of the solar cell, and photons pass through the subcells, with each subcell being designed for photons in a specific wavelength band. After passing through a subcell, the photons that are not absorbed and converted to electrical energy propagate to the next subcells, where such photons are intended to be captured and converted to electrical energy.

The energy conversion efficiency of multijunction solar cells is affected by such factors as the number of subcells, the thickness of each subcell, the composition and doping of each active layer in a subcell, and the consequential band structure, electron energy levels, conduction, and absorption of each subcell, as well as the effect of its exposure to radiation in the ambient environment over time. The identification and specification of such design parameters is a non-trivial engineering undertaking, and would vary depending upon the specific space mission and customer design requirements. Since the power output is a function of both the voltage and the current produced by a subcell, a simplistic view may seek to maximize both parameters in a subcell by increasing a constituent element, or the doping level, to achieve that effect. However, in reality, changing a material parameter that increases the voltage may result in a decrease in current, and therefore a lower power output. Such material design parameters are interdependent and interact in complex and often unpredictable ways, and for that reason are not "result effective" variables that those skilled in the art confronted with complex design specifications and practical operational considerations can easily adjust to optimize performance. Electrical properties such as the short circuit current density (J_{sc}), the open circuit voltage (V_{oc}), and the fill factor (FF), which determine the efficiency and power output of the solar cell, are affected by the slightest change in such design variables, and as noted above, to further complicate the calculus, such variables and resulting properties also vary, in a non-uniform manner, over time (i.e. during the operational life of the system) due to exposure to radiation during space missions.

Another important mechanical or structural consideration in the choice of semiconductor layers for a solar cell is the desirability of the adjacent layers of semiconductor materials in the solar cell, i.e. each layer of crystalline semiconductor material that is deposited and grown to form a solar subcell, have similar crystal lattice constants or parameters.

Document US9768329 discloses a multijunction solar cell with a layer for scattering and reflecting light adjacent to the bottom cell.

Document "A 19.9%-efficient ultrathin solar cell based on a 205-nm-thick GaAs absorber and a silver nanostructured back mirror", Chen Hung-Ling et al., Nature Energy vol. 4 pp 761-767, Sept. 2019, and document "Performance benefits for thin film solar cells incorporating semiconductor heterostructures and light trapping", C. O McPheeters et al., Photovoltaic Specialists Conference (PVSC), 2012 38th IEEE, pp. 1566-1571, describe a solar cell with a back mirror having light scattering elements.

### SUMMARY OF THE DISCLOSURE

### Objects of the Disclosure

It is an object of the present disclosure to provide increased photoconversion efficiency in a multijunction solar cell for space applications by providing a light scattering layer in the solar cell for internally redirecting the incoming light;

It is another object of the present disclosure to optimize the efficiency of a solar cell for operation at a temperature of approximately 47° C.

It is another object of the present disclosure to provide a multijunction solar cell in which the efficiency is optimized for operation in a 1200 km LEO satellite orbit.

It is another object of the present invention to provide a two junction solar cell for low temperature, low alpha operation.

Some implementations of the present disclosure may incorporate or implement fewer of the aspects and features noted in the foregoing objects.

### Features of the Invention

All ranges of numerical parameters set forth in this disclosure are to be understood to encompass any and all subranges or "intermediate generalizations" subsumed herein. For example, a stated range of "1.0 to 2.0 eV" for a band gap value should be considered to include any and all subranges beginning with a minimum value of 1.0 eV or more and ending with a maximum value of 2.0 eV or less, e.g., 1.0 to 2.0, or 1.3 to 1.4, or 1.5 to 1.9 eV.

Briefly, and in general terms, a multijunction solar cell is described and comprises a two junction solar cell comprising: an upper solar subcell composed of InGaP and having an emitter of n conductivity type with a first band gap and a thickness in the range of 40 - 150 nm and a base of p conductivity type and a thickness in the range of 400 - 900 nm; a bottom solar subcell adjacent to the upper solar subcell composed of (In)GaAs having an emitter of n conductivity type with a third band gap and a thickness in the range of 40 to 550 nm and a base of p conductivity type and a thickness in the range of 300 - 2500 nm; a layer of light scattering elements below and adjacent to the bottom solar subcell; and a metallic layer disposed below and adjacent to the layer of light scattering elements.

The invention is defined by the subject-matter of claims 1 and 8.

In the solar cell according to the invention, the layer of light scattering elements includes discrete periodic arrayed elements having a height of 200 - 500 nm, a width of 200 - 500 nm, and a pitch of 200 - 500 nm.

In some embodiments, the bottom surface of the bottom solar subcell is roughened.

In some embodiments, an oxide layer is deposited over the roughened surface of the bottom solar subcell such that the layer of light scattering elements includes the oxide layer.

In some embodiments, the layer of light scattering elements redirects the incoming light to be totally internally reflected into the solar subcell.

In some embodiments, the bottom solar subcell is a heterojunction subcell with a (In)GaAs emitter and a (Al)(In)GaAs or (Al)InGaP base, with the emitter having a thickness of 150 to 550 nm, and the base from 100 to 2500 nm.

In some embodiments, the layer of light scattering elements is composed of semiconductor material.

In some embodiments, the layer of light scattering elements is composed of metal elements.

In some embodiments, the layer of light scattering elements is formed by metal, oxide, polymer or semiconductor nanoparticles.

In some embodiments, the layer of light scattering elements is formed by phase separation of polymer blends.

In some embodiments, the bottom solar subcell is a homojunction solar cell with an emitter having a thickness of 40 to 550 nm and a base having a thickness of 300 to 2500 nm.

The efficiency of the solar cell can be optimized for an operating temperature of approximately 47°C.

In an example, the present disclosure provides a two junction solar cell comprising: an upper solar subcell composed of InGaP and having an emitter of n conductivity type with a first band gap; a bottom solar subcell adjacent to the upper solar subcell composed of (In)GaAs having an emitter of n conductivity type with a second band gap less than the first band gap and a base of p conductivity type; a light scattering layer disposed below and directly adjacent to the bottom solar subcell to reflect incoming light into the solar subcell; and a metallic layer disposed below and directly adjacent to the layer of light scattering elements.

In an example, the present disclosure provides a method of manufacturing a two junction solar cell comprising: providing a semiconductor growth substrate; depositing on the semiconductor growth substrate an etch stop layer; depositing a first sequence of layers of semiconductor material forming a first solar subcell on the etch stop layer; depositing a second sequence of layers of semiconductor material forming a lattice matched second solar subcell over the first solar subcell; forming a layer of light scattering elements over and adjacent to the second solar subcell; mounting and bonding a surrogate substrate on top of the sequence of layers; and removing the semiconductor growth substrate.

In an example, the present disclosure provides a method of manufacturing a two junction solar cell comprising: providing a semiconductor growth substrate; depositing on the semiconductor growth substrate an etch stop layer; depositing a first sequence of layers of semiconductor material forming a first solar subcell on the etch stop layer; depositing a second sequence of layers of semiconductor material forming a lattice matched second solar subcell over the first solar subcell; roughening the top surface of the second solar subcell; forming an oxide layer over and adjacent to the top surface of the second solar subcell; mounting and bonding a surrogate substrate on top of the sequence of layers; and removing the semiconductor growth substrate.

In some embodiments, the layer of light scattering elements is formed by: (i) electron beam lithography; or (ii) nanoimprint lithography; or (iii) nanoparticle self-assembly; or (iv) PDMS wrinkle self-assembly; or (v) phase separation of polymer blends; or (vi) chemical or physical etching, followed by grinding and polishing; or (vii) semiconductor growth conditions that produce a rough semiconductor surface.

In some embodiments, the first solar subcell is composed of InGaP and having an emitter of n conductivity type with a first band gap; and the second solar subcell is composed if (In)GaAs having an emitter of n conductivity type with a second band gap less than the first band gap and a base of p conductivity type.

In some embodiments, additional layer(s) may be added or deleted in the cell structure as long as the resulting device or method does not depart from the scope of the invention defined by the subject-matter of claims 1 and 8.

Some implementations of the present disclosure may incorporate or implement fewer of the aspects and features noted in the foregoing summaries.

Additional aspects, advantages, and novel features of the present disclosure will become apparent to those skilled in the art from this disclosure, including the following detailed description as well as by practice of the disclosure. While the disclosure is described below with reference to preferred embodiments, it should be understood that the disclosure is not limited thereto.

### BRIEF DESCRIPTION OF THE DRAWINGS

The present disclosure will be better and more fully appreciated by reference to the following detailed description when considered in conjunction with the accompanying drawings, wherein:
FIG. 1A is a cross-sectional view of a two junction solar cell after several stages of fabrication including the deposition of certain semiconductor layers on the growth substrate, and removal of the growth substrate;
FIG. 1B is a cross-sectional view of the two junction solar cell of FIG. 1A depicting the internal reflection of an incoming light beam; and
FIG. 2 is a graph depicting the alpha or AM0 efficiency as a function of the bottom subcell band gap.

### GLOSSARY OF TERMS

"III-V compound semiconductor" refers to a compound semiconductor formed using at least one elements from group III of the periodic table and at least one element from group V of the periodic table. III-V compound semiconductors include binary, tertiary and quaternary compounds. Group III includes boron (B), aluminum (Al), gallium (Ga), indium (In) and thallium (T). Group V includes nitrogen (N), phosphorus (P), arsenic (As), antimony (Sb) and bismuth (Bi).

"Band gap" refers to an energy difference (e.g., in electron volts (eV)) separating the top of the valence band and the bottom of the conduction band of a semiconductor material.

"Beginning of Life (BOL)" refers to the time at which a photovoltaic power system is initially deployed in operation.

"Bottom subcell" refers to the subcell in a multijunction solar cell which is furthest from the primary light source for the solar cell.

"Compound semiconductor" refers to a semiconductor formed using two or more chemical elements.

"Current density" refers to the short circuit current density J_{sc} through a solar subcell through a given planar area, or volume, of semiconductor material constituting the solar subcell.

"Deposited", with respect to a layer of semiconductor material, refers to a layer of material which is epitaxially grown over another semiconductor layer.

"End of Life (EOL)" refers to a predetermined time or times after the Beginning of Life, during which the photovoltaic power system has been deployed and has been operational. The EOL time or times may, for example, be specified by the customer as part of the required technical performance specifications of the photovoltaic power system to allow the solar cell designer to define the solar cell subcells and sublayer compositions of the solar cell to meet the technical performance requirement at the specified time or times, in addition to other design objectives. The terminology "EOL" is not meant to suggest that the photovoltaic power system is not operational or does not produce power after the EOL time.

"Graded interlayer" (or "grading interlayer") - see "metamorphic layer".

"Inverted metamorphic multijunction solar cell" or "IMM solar cell" refers to a solar cell in which the subcells are deposited or grown on a substrate in a "reverse" sequence such that the higher band gap subcells, which would normally be the "top" subcells facing the solar radiation in the final deployment configuration, are deposited or grown on a growth substrate prior to depositing or growing the lower band gap subcells.

"Layer" refers to a relatively planar sheet or thickness of semiconductor or other material. The layer may be deposited or grown, e.g., by epitaxial or other techniques.

"Lattice mismatched" refers to two adjacently disposed materials or layers (with thicknesses of greater than 100 nm) having in - plane lattice constants of the materials in their fully relaxed state differing from one another by less than 0.02% in lattice constant. (Applicant expressly adopts this definition for the purpose of this disclosure, and notes that this definition is considerably more stringent than that proposed, for example, in U.S. Patent No. 8,962,993, which suggests less than 0.6% lattice constant difference).

"Metamorphic layer" or "graded interlayer" refers to a layer that achieves a gradual transition in lattice constant generally throughout its thickness in a semiconductor structure.

"Middle subcell" refers to a subcell in a multijunction solar cell which is neither a Top Subcell (as defined herein) nor a Bottom Subcell (as defined herein).

"Short circuit current (I_{sc})" refers to the amount of electrical current through a solar cell or solar subcell when the voltage across the solar cell is zero volts, as represented and measured, for example, in units of milliamps.

"Short circuit current density" - see "current density".

"Solar cell" refers to an electronic device operable to convert the energy of light directly into electricity by the photovoltaic effect.

"Solar cell assembly" refers to two or more solar cell subassemblies interconnected electrically with one another.

"Solar cell subassembly" refers to a stacked sequence of layers including one or more solar subcells.

"Solar subcell" refers to a stacked sequence of layers including a p-n photoactive junction composed of semiconductor materials. A solar subcell is designed to convert photons over different spectral or wavelength bands to electrical current.

"Substantially current matched" refers to the short circuit current through adjacent solar subcells being substantially identical (i.e. within plus or minus 1%).

"Top subcell" or "upper subcell" refers to the subcell in a multijunction solar cell which is closest to the primary light source for the solar cell.

"ZTJ" refers to the product designation of a commercially available SolAero Technologies Corp. triple j unction solar cell.

### DESCRIPTION OF THE PREFERRED EMBODIMENT

Details of the present invention will now be described including exemplary aspects and embodiments thereof. Referring to the drawings and the following description, like reference numbers are used to identify like or functionally similar elements, and are intended to illustrate major features of exemplary embodiments in a highly simplified diagrammatic manner. Moreover, the drawings are not intended to depict every feature of the actual embodiment nor the relative dimensions of the depicted elements, and are not drawn to scale.

A variety of different features of multijunction solar cells (as well as inverted metamorphic multijunction solar cells) are disclosed in the related applications noted above. Some, many or all of such features may be included in the structures and processes associated with the inverted multijunction solar cells of the present disclosure.

Prior to discussing the specific embodiments of the present disclosure, a brief discussion of some of the issues associated with the design of multijunction solar cells, and the context of the composition or deposition of various specific layers in embodiments of the product as specified and defined by Applicant is in order.

There are a multitude of properties that should be considered in specifying and selecting the composition of, inter alia, a specific semiconductor layer, the back metal layer, the adhesive or bonding material, or the composition of the supporting material for mounting a solar cell thereon. For example, some of the properties that should be considered when selecting a particular layer or material are electrical properties (e.g. conductivity), optical properties (e.g., band gap, absorbance and reflectance), structural properties (e.g., thickness, strength, flexibility, Young's modulus, etc.), chemical properties (e.g., growth rates, the "sticking coefficient" or ability of one layer to adhere to another, stability of dopants and constituent materials with respect to adjacent layers and subsequent processes, etc.), thermal properties (e.g., thermal stability under temperature changes, coefficient of thermal expansion), and manufacturability (e.g., availability of materials, process complexity, process variability and tolerances, reproducibility of results over high volume, reliability and quality control issues).

In view of the trade-offs among these properties, it is not always evident that the selection of a material based on one of its characteristic properties is always or typically "the best" or "optimum" from a commercial standpoint or for Applicant's purposes. For example, theoretical studies may suggest the use of a quaternary material with a certain band gap for a particular subcell would be the optimum choice for that subcell layer based on fundamental semiconductor physics. As an example, the teachings of academic papers and related proposals for the design of very high efficiency (over 40%) solar cells may therefore suggest that a solar cell designer specify the use of a quaternary material (e.g., InGaAsP) for the active layer of a subcell. A few such devices may actually be fabricated by other researchers, efficiency measurements made, and the results published as an example of the ability of such researchers to advance the progress of science by increasing the demonstrated efficiency of a compound semiconductor multijunction solar cell. Although such experiments and publications are of "academic" interest, from the practical perspective of the Applicants in designing a compound semiconductor multijunction solar cell to be produced in high volume at reasonable cost and subject to manufacturing tolerances and variability inherent in the production processes, such an "optimum" design from an academic perspective is not necessarily the most desirable design in practice, and the teachings of such studies more likely than not point in the wrong direction and lead away from the proper design direction. Stated another way, such references may actually "teach away" from Applicant's research efforts and direction and the ultimate solar cell design proposed by the Applicants.

In view of the foregoing, it is further evident that the identification of one particular constituent element (e.g. indium, or aluminum) in a particular subcell, or the thickness, band gap, doping, or other characteristic of the incorporation of that material in a particular subcell, is not a single "result effective variable" that one skilled in the art can simply specify and incrementally adjust to a particular level and thereby increase the power output and efficiency of a solar cell.

Even when it is known that particular variables have an impact on electrical, optical, chemical, thermal or other characteristics, the nature of the impact often cannot be predicted with much accuracy, particularly when the variables interact in complex ways, leading to unexpected results and unintended consequences. Thus, significant trial and error, which may include the fabrication and evaluative testing of many prototype devices, often over a period of time of months if not years, is required to determine whether a proposed structure with layers of particular compositions, actually will operate as intended, let alone whether it can be fabricated in a reproducible high volume manner within the manufacturing tolerances and variability inherent in the production process, and necessary for the design of a commercially viable device.

Furthermore, as in the case here, where multiple variables interact in unpredictable ways, the proper choice of the combination of variables can produce new and unexpected results, and constitute an "inventive step".

The efficiency of a solar cell is not a simple linear algebraic equation as a function of the amount of gallium or aluminum or other element in a particular layer. The growth of each of the epitaxial layers of a solar cell in a reactor is a non-equilibrium thermodynamic process with dynamically changing spatial and temporal boundary conditions that is not readily or predictably modeled. The formulation and solution of the relevant simultaneous partial differential equations covering such processes are not within the ambit of those of ordinary skill in the art in the field of solar cell design.

More specifically, the present disclosure intends to provide a relatively simple and reproducible technique that is suitable for use in a high volume production environment in which various semiconductor layers are grown on a growth substrate in an MOCVD reactor, and subsequent processing steps are defined and selected to minimize any physical damage to the quality of the deposited layers, thereby ensuring a relatively high yield of operable solar cells meeting specifications at the conclusion of the fabrication processes.

The lattice constants and electrical properties of the layers in the semiconductor structure are preferably controlled by specification of appropriate reactor growth temperatures and times, and by use of appropriate chemical composition and dopants. The use of a deposition method, such as Molecular Beam Epitaxy (MBE), Organo Metallic Vapor Phase Epitaxy (OMVPE), Metal Organic Chemical Vapor Deposition (MOCVD), or other vapor deposition methods for the growth may enable the layers in the monolithic semiconductor structure forming the cell to be grown with the required thickness, elemental composition, dopant concentration and grading and conductivity type, and are within the scope of the present disclosure.

The present disclosure is in one embodiment directed to a growth process using a metal organic chemical vapor deposition (MOCVD) process in a standard, commercially available reactor suitable for high volume production. Other embodiments may use other growth technique, such as MBE. More particularly, regardless of the growth technique, the present disclosure is directed to the materials and fabrication steps that are particularly suitable for producing commercially viable multijunction solar cells or inverted metamorphic multijunction solar cells using commercially available equipment and established high-volume fabrication processes, as contrasted with merely academic expositions of laboratory or experimental results.

Some comments about MOCVD processes used in one embodiment are in order here.

It should be noted that the layers of a certain target composition in a semiconductor structure grown in an MOCVD process are inherently physically different than the layers of an identical target composition grown by another process, e.g. Molecular Beam Epitaxy (MBE). The material quality (i.e., morphology, stoichiometry, number and location of lattice traps, impurities, and other lattice defects) of an epitaxial layer in a semiconductor structure is different depending upon the process used to grow the layer, as well as the process parameters associated with the growth. MOCVD is inherently a chemical reaction process, while MBE is a physical deposition process. The chemicals used in the MOCVD process are present in the MOCVD reactor and interact with the wafers in the reactor, and affect the composition, doping, and other physical, optical and electrical characteristics of the material. For example, the precursor gases used in an MOCVD reactor (e.g. hydrogen) are incorporated into the resulting processed wafer material, and have certain identifiable electro-optical consequences which are more advantageous in certain specific applications of the semiconductor structure, such as in photoelectric conversion in structures designed as solar cells. Such high order effects of processing technology do result in relatively minute but actually observable differences in the material quality grown or deposited according to one process technique compared to another. Thus, devices fabricated at least in part using an MOCVD reactor or using a MOCVD process have inherent different physical material characteristics, which may have an advantageous effect over the identical target material deposited using alternative processes.

Reference throughout this specification to "one embodiment" or "an embodiment" means that a particular feature, structure, or characteristic described in connection with the embodiment is included in at least one embodiment of the present invention. Thus, the appearances of the phrases "in one embodiment" or "in an embodiment" in various places throughout this specification are not necessarily all referring to the same embodiment. Furthermore, the particular features, structures, or characteristics may be combined in any suitable manner in one or more embodiments.

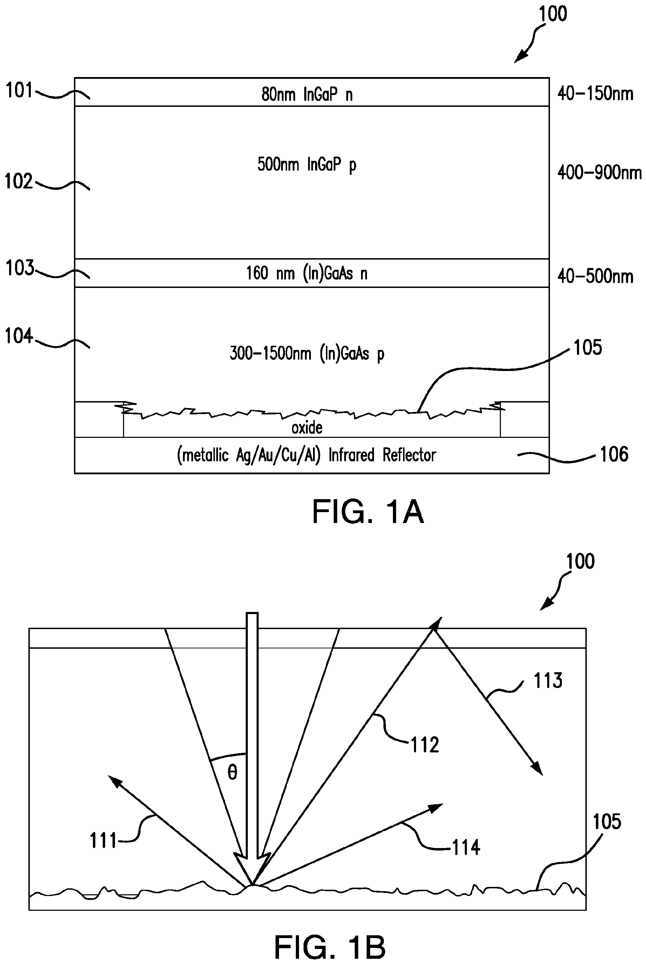

FIG. 1A illustrates a particular example of an embodiment of a two junction solar cell 100 after several stages of fabrication including the growth of certain semiconductor layers on the growth substrate (not shown) up to the top layer 101 of the semiconductor body as provided by the present disclosure.

As shown in the illustrated example of FIG. 1A, the solar cell 100 includes a bottom subcell B includes a layer 104 formed of p-type (In)GaAs which serves as a base layer. A back metal contact 106 is formed on the bottom of base layer 104 provides electrical contact to the multijunction solar cell 100. The bottom subcell B, further includes, for example, a highly doped n-type (In)GaAs emitter layer 103.

In the illustrated example, the top subcell A includes a p-type (In)GaAs base layer 102, a highly doped n-type (In)GaAs emitter layer 101 and a highly doped n-type InAlP₂ window layer.

A cap or contact layer 216 of GaAs is deposited over the window layer 215.

The overall current produced by the multijunction cell solar cell may be raised by increasing the current produced by top subcell. Additional current can be produced by top subcell by increasing the thickness of the p-type InGaAlP2 base layer in that cell. The increase in thickness allows additional photons to be absorbed, which results in additional current generation. Preferably, for space or AM0 applications, the increase in thickness of the top subcell maintains the approximately 4 to 5% difference in current generation between the top subcell A and middle subcell C. For AM1 or terrestrial applications, the current generation of the top cell and the middle cell may be chosen to be equalized.

FIG. 1B is a cross-sectional view of the two junction solar cell of FIG .1A depicting the internal reflection of an incoming light beam.

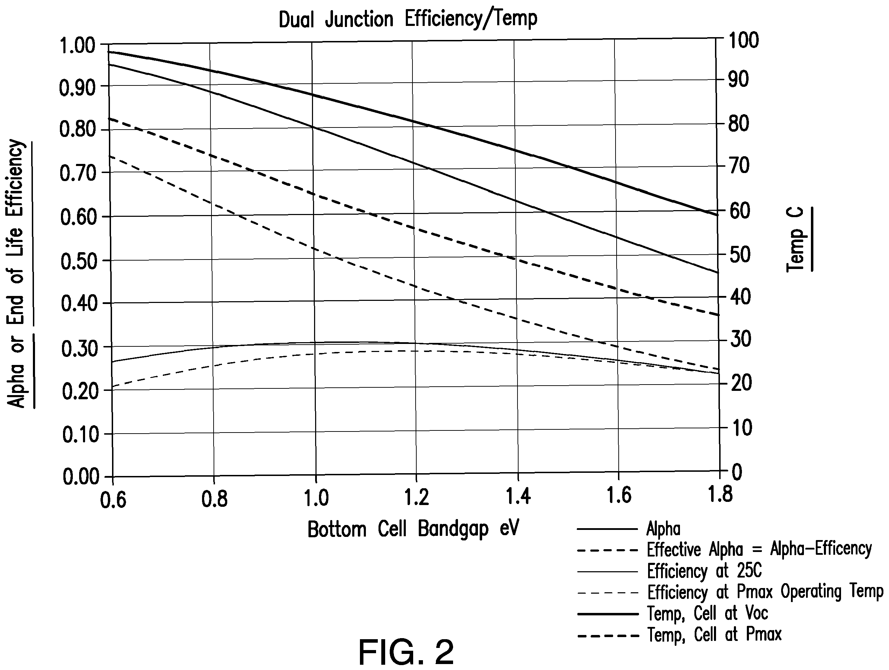

FIG. 2 is a graph depicting the alpha or AM0 efficiency as a function of the bottom subcell band gap.

The lower graph in the Figure, which indicates that there is a very broad range of band gaps (and therefore material selection options) for the lower subcell which will produce a broad range of solar cells with a comparatively high degree of efficiency. The different band gaps correspond to different material compositions for the lower subcell. The design principle according to the present disclosure is not to automatically select the material composition with the band gap corresponding to the highest point of the lower graph but to judiciously select the combination of materials for both the upper subcell and the lower subcell which provides the most stable epitaxial structure, i.e. the absence of tension and strain between the layers which would result in dislocations and compromise the efficiency of the solar cell. (In other words, the selection of any specific band gap corresponding to an optimal, or even sub-optimal, efficiency is not readily apparent to provide the most stable epitaxial structure, and the choice of the band gap alone is not a "result effective" variable in such a design paradigm).

It will be understood that each of the elements described above, or two or more together, also may find a useful application in other types of structures or constructions differing from the types of structures or constructions described above.

Although described embodiments of the present disclosure utilizes a vertical stack of three subcells, various aspects and features of the present disclosure can apply to stacks with fewer or greater number of subcells, i.e. two junction cells, three junction cells, five, six, seven junction cells, etc.

In addition, although the disclosed embodiments are configured with top and bottom electrical contacts, the subcells may alternatively be contacted by means of metal contacts to laterally conductive semiconductor layers between the subcells. Such arrangements may be used to form 3-terminal, 4-terminal, and in general, n-terminal devices. The subcells can be interconnected in circuits using these additional terminals such that most of the available photogenerated current density in each subcell can be used effectively, leading to high efficiency for the multijunction cell, notwithstanding that the photogenerated current densities are typically different in the various subcells.

As noted above, the solar cell described in the present disclosure may utilize an arrangement of one or more, or all, homojunction cells or subcells, i.e., a cell or subcell in which the p-n junction is formed between a p-type semiconductor and an n-type semiconductor both of which have the same chemical composition and the same band gap, differing only in the dopant species and types, and one or more heterojunction cells or subcells. Subcell 309, with p-type and n-type InGaP is one example of a homojunction subcell.

In some cells, a thin so-called "intrinsic layer" may be placed between the emitter layer and base layer, with the same or different composition from either the emitter or the base layer. The intrinsic layer may function to suppress minority-carrier recombination in the space-charge region. Similarly, either the base layer or the emitter layer may also be intrinsic or not-intentionally-doped ("NID") over part or all of its thickness.

The composition of the window or BSF layers may utilize other semiconductor compounds, subject to lattice constant and band gap requirements, and may include AlInP, AlAs, AlP, AlGaInP, AlGaAsP, AlGaInAs, AlGaInPAs, GaInP, GaInAs, GaInPAs, AlGaAs, AlInAs, AlInPAs, GaAsSb, AlAsSb, GaAlAsSb, AlInSb, GaInSb, AlGaInSb, AIN, GaN, InN, GaInN, AlGaInN, GaInNAs, AlGaInNAs, ZnSSe, CdSSe, and similar materials, and still fall within the spirit of the present invention.

While the solar cell described in the present disclosure has been illustrated and described as embodied in a conventional multijunction solar cell, it is not intended to be limited to the details shown, since it is also applicable to inverted metamorphic solar cells, and various modifications and structural changes may be made without departing in any way from the spirit of the present invention.

Thus, while the description of the semiconductor device described in the present disclosure has focused primarily on solar cells or photovoltaic devices, persons skilled in the art know that other optoelectronic devices, such as thermophotovoltaic (TPV) cells, photodetectors and light-emitting diodes (LEDS), are very similar in structure, physics, and materials to photovoltaic devices with some minor variations in doping and the minority carrier lifetime. For example, photodetectors can be the same materials and structures as the photovoltaic devices described above, but perhaps more lightly-doped for sensitivity rather than power production. On the other hand LEDs can also be made with similar structures and materials, but perhaps more heavily-doped to shorten recombination time, thus radiative lifetime to produce light instead of power. Therefore, the teaching of this disclosure could also be applied to photodetectors and LEDs with structures, compositions of matter, articles of manufacture, and improvements as described above for photovoltaic cells.

Without further analysis, from the foregoing others can, by applying current knowledge, readily adapt the present invention for various applications. Such adaptations should and are intended to be comprehended within the scope of the following claims.

## Claims

1. A multijunction solar cell comprising:
an upper solar subcell composed of a first compound semiconductor material and having an emitter (101) of n conductivity type with a first band gap;
a bottom solar subcell adjacent to the upper solar subcell composed of a second compound semiconductor material different from the first and having an emitter (103) of n conductivity type with a second band gap less than the first band gap and a base (104) of p conductivity type;
a layer of light scattering elements disposed below and directly adjacent to the bottom solar subcell to reflect incoming light into the solar subcell, and
a metallic layer disposed below and directly adjacent to the layer of light scattering elements,
**characterized in that** the layer of light scattering elements includes discrete periodic arrayed elements having a height of 200 - 500 nm, a width of 200 - 500 nm, and a pitch of 200 - 500 nm.

2. A multijunction solar cell as defined in claim 1, wherein the bottom surface of the bottom solar subcell is roughened, and the layer of light scattering elements includes a surface oxide layer disposed over the roughened semiconductor surface.

3. A multijunction solar cell as defined in any of the preceding claims, wherein the layer of light scattering elements redirects the incoming light to be totally internally reflected into the bottom solar subcell.

4. A multijunction solar cell as defined in any of the preceding claims, wherein the bottom solar subcell is a heterojunction subcell with a (In)GaAs emitter and a (Al)(In)GaAs or (Al)InGaP base, with the emitter having a thickness of 150 to 550 nm, and the base from 100 to 2500 nm.

5. A multijunction solar cell as defined in any of claims 1 to 3, wherein the bottom solar subcell is a homojunction solar cell with an emitter having a thickness of 40 to 550 nm and a base having a thickness of 300 to 2500 nm.

6. A multijunction solar cell as defined in any of the preceding claims, wherein the upper solar subcell is composed of InGaP.

7. A multijunction solar cell as defined in any of the preceding claims, wherein the layer of light scattering elements is selected from the group consisting of:
(i) semiconductor material;
(ii) metal elements;
(iii) metal, oxide, polymer, or semiconductor nanoparticles; or
(iv) a phase separation of polymer blends.

8. A method of manufacturing a multijunction solar cell comprising:
providing a semiconductor growth substrate;
depositing on the semiconductor growth substrate an etch stop layer;
depositing a first sequence of layers of semiconductor material forming a first solar subcell on the etch stop layer;
depositing a second sequence of layers of semiconductor material forming a lattice matched second solar subcell over the first solar subcell;
forming a layer of light scattering elements over and adjacent to the second solar subcell;
mounting and bonding a surrogate substrate on top of the sequence of layers; and
removing the semiconductor growth substrate;
wherein the light scattering layer is disposed below and directly adjacent to the second solar subcell to reflect incoming light into the solar subcell; and further comprising providing a metallic layer disposed below and directly adjacent to the layer of light scattering elements; and
wherein the layer of light scattering elements includes discrete periodic arrayed elements having a height of 200 - 500 nm, a width of 200 - 500 nm, and a pitch of 200 - 500 nm.

9. A method as defined in claim 8, wherein the bottom surface of the second solar subcell is roughened, and the layer of light scattering elements includes a surface oxide layer disposed over the roughened semiconductor surface.

10. A method as defined in any of claims 8 or 9, wherein the layer of light scattering elements redirects the incoming light to be totally internally reflected into the second solar subcell.

11. A method as defined in any of the claims 8 - 10, wherein the layer of light scattering elements is selected from the group consisting of:
(i) semiconductor material;
(ii) metal elements;
(iii) metal, oxide, polymer, or semiconductor nanoparticles; or
(iv) a phase separation of polymer blends.

## Patentansprüche

1. Eine Mehrfachsolarzelle, bestehend aus:
eine obere Solarsubzelle, die aus einem ersten Verbindungshalbleitermaterial besteht und einen Emitter (101) vom n-Leitfähigkeitstyp mit einer ersten Bandlücke
aufweist;
eine untere Solarsubzelle, die an die obere Solarsubzelle angrenzt und aus einem zweiten Verbindungshalbleitermaterial besteht, das sich von dem ersten unterscheidet und einen Emitter (103) aufweist vom n-Leitfähigkeitstyp mit einer zweiten Bandlücke, die kleiner als die erste Bandlücke ist, und einer Basis (104) vom p-Leitfähigkeitstyp;
eine Schicht aus lichtstreuenden Elementen, die unterhalb und direkt angrenzend an die untere Solarsubzelle angeordnet ist, um ankommendes Licht in die Solarsubzelle zu reflektieren, und eine metallische Schicht, die unterhalb und direkt angrenzend an die Schicht aus lichtstreuenden Elementen angeordnet ist, **dadurch gekennzeichnet, dass** die Schicht aus lichtstreuenden Elementen diskrete periodisch angeordnete Elemente mit einer Höhe von 200 - 500 nm, einer Breite von 200 - 500 nm und einem Abstand von 200 - 500 nm umfasst.

2. Eine Mehrfachsolarzelle nach Anspruch 1, wobei die untere Oberfläche der unteren Solarsubzelle aufgeraut ist und die Schicht aus lichtstreuenden Elementen eine Oberflächenoxidschicht enthält, die über der aufgerauten Halbleiteroberfläche angeordnet ist.

3. Eine Mehrfachsolarzelle nach einem der vorhergehenden Ansprüche, wobei die Schicht aus lichtstreuenden Elementen das einfallende Licht so umlenkt, dass es vollständig in die untere Solarsubzelle reflektiert wird.

4. Mehrfachsolarzelle nach einem der vorhergehenden Ansprüche, wobei die untere Solarsubzelle eine Heteroübergangs-Subzelle mit einem (In)GaAs-Emitter und einer (Al)(In)GaAs- oder (Al)InGaP-Basis ist, wobei der Emitter eine Dicke von 150 bis 550 nm und die Basis von 100 bis 2500 nm aufweist.

5. Eine Mehrfachsolarzelle nach einem der Ansprüche 1 bis 3, wobei die untere Solarsubzelle eine Homoübergangs-Solarzelle mit einem Emitter mit einer Dicke von 40 bis 550 nm und einer Basis mit einer Dicke von 300 bis 2500 nm ist.

6. Eine Mehrfachsolarzelle nach einem der vorhergehenden Ansprüche, wobei die obere Solarsubzelle aus InGaP besteht.

7. Eine Mehrfachsolarzelle nach einem der vorhergehenden Ansprüche, wobei die Schicht aus lichtstreuenden Elementen ausgewählt ist aus der Gruppe bestehend aus:
(i) Halbleitermaterial;
(ii) Metallelemente;
(iii) Metall-, Oxid-, Polymer- oder Halbleiter-Nanopartikel; oder
(iv) eine Phasentrennung von Polymermischungen.

8. Ein Verfahren zur Herstellung einer Mehrfachsolarzelle, umfassend:
Bereitstellung eines Halbleiterwachstumssubstrats;
Ablagerung einer Ätzstoppschicht auf dem Halbleiterwachstumssubstrat;
Abscheidung einer ersten Folge von Schichten aus Halbleitermaterial, die eine erste Solarsubzelle bilden, auf der Ätzstoppschicht;
Abscheidung einer zweiten Folge von Schichten aus Halbleitermaterial, die eine gitterangepasste zweite Teilsolarzelle über der ersten Teilsolarzelle bilden;
Bildung einer Schicht aus lichtstreuenden Elementen über und neben der zweiten Teilsolarzelle;
Anbringen und Verkleben eines Ersatzsubstrats auf der Schichtenfolge; und
Entfernen des Halbleiterwachstumssubstrats;
wobei die lichtstreuende Schicht unterhalb und direkt angrenzend an die zweite Solarsubzelle angeordnet ist, um ankommendes Licht in die Solarsubzelle zu reflektieren; und ferner umfassend das Bereitstellen einer metallischen Schicht, die unterhalb und direkt angrenzend an die Schicht der lichtstreuenden Elemente angeordnet ist; und
wobei die Schicht aus lichtstreuenden Elementen diskrete periodisch angeordnete Elemente mit einer Höhe von 200 - 500 nm, einer Breite von 200 - 500 nm und einem Abstand von 200 - 500 nm umfasst.

9. Verfahren nach Anspruch 8, wobei die untere Oberfläche der zweiten Teilsolarzelle aufgeraut ist und die Schicht aus lichtstreuenden Elementen eine Oberflächenoxidschicht enthält, die über der aufgerauten Halbleiteroberfläche angeordnet ist.

10. Verfahren nach einem der Ansprüche 8 oder 9, wobei die Schicht aus lichtstreuenden Elementen das einfallende Licht so umlenkt, dass es vollständig in die zweite Solarsubzelle reflektiert wird.

11. Verfahren nach einem der Ansprüche 8 bis 10, wobei die Schicht aus lichtstreuenden Elementen ausgewählt ist aus der Gruppe bestehend aus:
(i) Halbleitermaterial;
(ii) Metallelemente;
(iii) Metall-, Oxid-, Polymer- oder Halbleiter-Nanopartikel; oder
(iv) eine Phasentrennung von Polymermischungen.

## Revendications

1. Une cellule solaire multijonction comprenant :
une sous-cellule solaire supérieure composée d'un premier matériau semi-conducteur composé et comportant un émetteur (101) de type à conductivité n avec une première bande interdite ;
une sous-cellule solaire inférieure adjacente à la sous-cellule solaire supérieure, composée d'un second matériau semi-conducteur composé différent du premier et comportant un émetteur (103) de type conductivité n avec une seconde bande interdite inférieure à la première bande interdite et une base (104) de type conductivité p ;
une couche d'éléments de diffusion de la lumière disposés sous la sous-cellule solaire inférieure et directement adjacents à celle-ci afin de réfléchir la lumière entrante dans la sous-cellule solaire, et une couche métallique disposée sous la couche d'éléments de diffusion de la lumière et directement adjacente à celle-ci, **caractérisée par le fait que** la couche d'éléments de diffusion de la lumière comprend des éléments périodiques discrets en réseau ayant une hauteur de 200 à 500 nm, une largeur de 200 à 500 nm, et un pas de 200 à 500 nm.

2. Cellule solaire multijonction telle que définie dans la revendication 1, dans laquelle la surface inférieure de la sous-cellule solaire inférieure est rugueuse, et la couche d'éléments de diffusion de la lumière comprend une couche d'oxyde de surface disposée sur la surface semi-conductrice rugueuse.

3. Cellule solaire multijonction telle que définie dans l'une des revendications précédentes, dans laquelle la couche d'éléments de diffusion de la lumière redirige la lumière entrante pour qu'elle soit totalement réfléchie à l'intérieur de la sous-cellule solaire inférieure.

4. Cellule solaire multijonction telle que définie dans l'une des revendications précédentes, dans laquelle la sous-cellule solaire inférieure est une sous-cellule à hétérojonction avec un émetteur en (In)GaAs et une base en (Al)(In)GaAs ou (Al)InGaP, l'émetteur ayant une épaisseur de 150 à 550 nm, et la base de 100 à 2500 nm.

5. Cellule solaire multijonction telle que définie dans l'une des revendications 1 à 3, dans laquelle la sous-cellule solaire inférieure est une cellule solaire homojonction avec un émetteur d'une épaisseur de 40 à 550 nm et une base d'une épaisseur de 300 à 2500 nm.

6. Cellule solaire multijonction telle que définie dans l'une des revendications précédentes, dans laquelle la sous-cellule solaire supérieure est composée d'InGaP.

7. Cellule solaire multijonction telle que définie dans l'une quelconque des revendications précédentes, dans laquelle la couche d'éléments de diffusion de la lumière est choisie dans le groupe constitué de :
(i) matériau semi-conducteur ;
(ii) les éléments métalliques ;
(iii) des nanoparticules de métal, d'oxyde, de polymère ou de semi-conducteur ; ou
(iv) une séparation de phase des mélanges de polymères.

8. Une méthode de fabrication d'une cellule solaire multijonction comprenant :
fournir un substrat de croissance semi-conducteur ;
dépôt d'une couche d'arrêt de gravure sur le substrat de croissance du semi-conducteur ;
dépôt d'une première séquence de couches de matériau semi-conducteur formant une première sous-cellule solaire sur la couche d'arrêt de gravure ;
dépôt d'une deuxième séquence de couches de matériau semi-conducteur formant une deuxième sous-cellule solaire adaptée au réseau sur la première sous-cellule solaire ;
former une couche d'éléments de diffusion de la lumière sur et à côté de la deuxième sous-cellule solaire ;
montage et collage d'un substrat de substitution sur la séquence de couches ; et
retirer le substrat de croissance du semi-conducteur ;
dans lequel la couche de diffusion de la lumière est disposée en dessous et directement adjacente à la seconde sous-cellule solaire pour réfléchir la lumière entrante dans la sous-cellule solaire ; et comprenant en outre la fourniture d'une couche métallique disposée en dessous et directement adjacente à la couche d'éléments de diffusion de la lumière ; et
la couche d'éléments de diffusion de la lumière comprend des éléments périodiques discrets en réseau ayant une hauteur de 200 à 500 nm, une largeur de 200 à 500 nm et un pas de 200 à 500 nm.

9. Méthode définie dans la revendication 8, dans laquelle la surface inférieure de la deuxième sous-cellule solaire est rugueuse, et la couche d'éléments de diffusion de la lumière comprend une couche d'oxyde de surface disposée sur la surface semi-conductrice rugueuse.

10. Méthode définie dans l'une des revendications 8 ou 9, dans laquelle la couche d'éléments de diffusion de la lumière redirige la lumière entrante pour qu'elle soit totalement réfléchie à l'intérieur de la deuxième sous-cellule solaire.

11. Méthode définie dans l'une des revendications 8 à 10, dans laquelle la couche d'éléments de diffusion de la lumière est choisie dans le groupe constitué par :
(i) matériau semi-conducteur ;
(ii) les éléments métalliques ;
(iii) des nanoparticules de métal, d'oxyde, de polymère ou de semi-conducteur ; ou
(iv) une séparation de phase des mélanges de polymères.
